# EUROPEAN PATENT APPLICATION

(11) **EP 4 752 170 A1**
(43) Date of publication of application: **03.06.2026**
(21) Application number: 24898954.3
(22) Date of filing: 11.07.2024
(51) Int. Cl.: C08J 5/18, B32B 15/20, B32B 15/082, B32B 27/20, B32B 27/30, C08J 3/215, H05K 1/03

(54) **FLUORORESIN SHEET, METHOD FOR PRODUCING SAME, AND METAL CLAD FLUORORESIN SUBSTRATE CONTAINING SAME**

(30) Priority: 07.12.2023 JP 2023207151
(71) Applicant: Fuji Polymer Industries Co., Ltd., Nagoya-shi, Aichi 450-0002 (JP)
(72) Inventor: KOBAYASHI Kazuki, Aichi 463-0026 (JP); NONOYAMA Tomohito, Aichi 463-0026 (JP)
(74) Representative: Dehns
(86) International application number: PCT/JP2024/025105
(87) International publication number: WO 2025/120893

(57) **Abstract**

A fluororesin sheet according to the present invention includes a fluoropolymer and an inorganic filler. The fluoropolymer is oriented in a surface direction of the fluororesin sheet. The inorganic filler is a surface-treated degreased sheet. A metal-clad laminate according to the present invention includes the above fluororesin sheet with a metal foil attached to at least one surface of the fluororesin sheet. A method according to the present invention includes a step of mixing an aqueous dispersion of a fluoropolymer and a pre-surface-treated inorganic filler to form a compound, and press-molding the compound to form a sheet, a step of laminating the sheet and press-molding the sheet to form a sheet, a step of rolling and thereafter drying the resulting sheet, and a step of degreasing the resulting sheet at a temperature of 200°C or more and below 300°C for 5 to 24 hours. A fluororesin sheet with good handleability by itself is thereby provided.

## Description

### Technical field

The present invention relates to a fluororesin sheet useful for printed circuit boards for high-speed communication using high-frequency waves such as millimeter waves and microwaves, a method for producing the same, and a metal-clad fluororesin substrate including the same.

### Background Art

With high-speed communication such as 5G, there is currently a strong demand for high-speed communication substrates and antenna substrates with lower transmission loss even when using high-frequency waves such as millimeter waves. In addition, high-density mounting and ultra-thin circuit boards have significantly advanced for information terminals such as smartphones. For high-speed communication such as 5G, widely-used printed circuit boards are produced by laminating a prepreg, which is obtained by impregnating a low-dielectric glass cloth such as D glass, NE glass, or L glass with thermoplastic resin such as fluororesin or polyphenylene ether, and also with thermosetting resin such as low-dielectric epoxy resin or low-dielectric maleimide resin, and heating and pressure-curing this prepreg.

Patent Document 1 proposes mixing a fluororesin with a low-molecular-weight polytetrafluoroethylene fine powder and an inorganic filler, and infiltrating the resulting mixture into a glass fiber cloth to produce a fluororesin prepreg. Patent Document 2 proposes subjecting a surface of a fluororesin prepreg infiltrated into glass fiber cloth to hydrophilic treatment to have an amino group and a hydroxyl group and attaching the surface to a metal foil. Patent Documents 3 to 7 propose laminating fluororesin sheets obtained by rolling in multiple stages.

### Prior Art Documents

### Patent Documents

[Patent Document 1] JP 2020-50860A
[Patent Document 2] JP 2022-114351A
[Patent Document 3] WO 2023/013569
[Patent Document 4] JP 2021-061406A
[Patent Document 5] WO 2021/235276
[Patent Document 6] JP 2008-238828A
[Patent Document 7] JP 2017-141345A

### Disclosure of Invention

### Problem to be Solved by the Invention

However, the fluororesin sheet is easy to break and is difficult to handle. In the foregoing Patent Documents 1 and 2, a prepreg is infiltrated into a glass fiber cloth to make a fluororesin prepreg to improve handleability. Meanwhile, there is a demand for a fluororesin sheet that does not use a glass fiber cloth and has good handleability by itself, and a metal-clad fluororesin substrate including this fluororesin sheet. In Patent Documents 3 to 7, the fluororesin sheet contains unnecessary organic matter, and defects due to bubbles are likely to occur upon heating to the heat press temperature in a copper foil application step.

To solve the above conventional problem, the present invention provides a fluororesin sheet that has good handleability by itself and in which bubbles are unlikely to occur upon heating to the heat press temperature in the copper foil application step, a method for producing the same, and a metal-clad fluororesin substrate including the same.

### Means for Solving Problem

One embodiment of the present invention relates to a fluororesin sheet including: a fluoropolymer; and an inorganic filler, the fluoropolymer is oriented in a surface direction of the fluororesin sheet, the inorganic filler is surface-treated, and the fluoropolymer is a degreased sheet.

Another embodiment of the present invention relates to a metal-clad laminate with a metal foil applied to at least one surface of the fluororesin sheet.

Yet another embodiment of the invention relates to a method for producing the fluororesin sheet that includes: a first step of mixing an aqueous dispersion of a fluoropolymer and a pre-surface-treated inorganic filler to form a compound, and press-molding the compound to form a sheet; a second step of laminating the sheet and press-molding the sheet to form a sheet; a third step of rolling and thereafter drying the resulting sheet; and a fourth step of degreasing the resulting sheet at a temperature of 200°C or more and below 300°C for 5 to 24 hours.

### Effects of the Invention

The present invention can provide: a fluororesin sheet with good handleability by itself due to being a degreased sheet and including a fluoropolymer and an inorganic filler, the fluoropolymer being oriented in a surface direction of the fluororesin sheet, and the inorganic filler being surface-treated; a method for producing the same; and a metal-clad fluororesin substrate including the same. The invention can reduce the water absorption rate (moisture absorption rate) and improve the electrical stability. In particular, employing a degreased sheet makes it possible to remove unnecessary organic matter and prevent defects due to bubbles even when the sheet is heated to the heat press temperature (around the melting point of fluororesin, namely 326°C) in the copper foil application step.

### Brief Description of Drawings

[FIG. 1] FIG. 1 is a cross-sectional SEM image of a fluororesin sheet according to Example 1 of the present invention (magnified 40 times).
[FIG. 2] FIG. 2 is a cross-sectional SEM image of a fluororesin sheet according to Comparative Example 1 (magnified 40 times).
[FIG. 3] FIG. 3 is a schematic perspective diagram of a copper-clad fluororesin substrate according to one embodiment of the present invention.
[FIG. 4] FIGS. 4A to 4D are schematic diagrams illustrating a method for producing the fluororesin sheet according to one embodiment of the present invention.

### Description of the Invention

The present inventors examined problems with the conventional fluororesin sheet, which is obtained by laminating a glass fiber cloth, and a metal-clad fluororesin substrate that includes this fluororesin sheet. The conventional fluororesin sheet is difficult to make into a thin film due to thickness restrictions of the glass fiber cloth, and, in terms of physical properties, the volume balance is also different between the fluororesin and the glass fiber cloth. Thus, it has been found that the dielectric permittivity fluctuates, resulting in a tendency for transmission characteristics to deteriorate at high frequencies compared to clothless products, and the high viscosity of fluororesin makes it difficult to infiltrate into the interior, which may result in issues such as air entrapment. The present invention has been completed under such an idea.

The fluororesin sheet according to the present invention contains a fluoropolymer and an inorganic filler, and the inorganic filler is surface-treated (pretreated). Preferably, the inorganic filler is silicon oxide, aluminum oxide, titanium oxide, aluminum nitride, boron nitride, silicon nitride, barium titanate, barium sulfate, magnesium hydroxide, glass particles, ceramic particles, or a combination thereof. These inorganic fillers can enhance the reinforcing effect of the fluororesin sheet. Pretreatment refers to fixing a surface treatment agent to the surface of the inorganic filler in advance before mixing the fluoropolymer and the inorganic filler.

The surface treatment agent is preferably a silane coupling agent, an aluminate coupling agent, or a titanate coupling agent. These surface treatment agents have a high affinity with fluoropolymers and, even when a large amount of inorganic filler is added to a fluoropolymer, they are easily mixed with the fluoropolymer and improve handleability. Furthermore, when the humidity rises, the inorganic filler absorbs moisture, which may increase the dielectric loss tangent. However, the moisture absorption and the increase in the dielectric loss tangent can be suppressed by surface-treating the inorganic filler. Specifically, hydroxyl groups (-OH groups) on the surface of the inorganic filler are blocked with the surface treatment agent, thereby making it possible to prevent moisture absorption. The water absorption rate is preferably 0.06% or less, and more preferably 0.01% to 0.06%. This makes it possible to prevent the transmission characteristics at high frequencies from deteriorating even when the humidity changes.

Among the surface treatment agents, silane coupling agents are preferred. Silane coupling agents may include alkylalkoxysilane compounds represented by the formula R(CH₃)ₐSi(OR')₄₋ₐ (R is an unsubstituted or substituted organic group having 1 to 20 carbon atoms, R' is an alkyl group having 1 to 4 carbon atoms, and a is 0 or 1), or partial hydrolysates thereof. Examples may include methyltrimethoxysilane, n-propyltrimethoxysilane, hexyltrimethoxysilane, decyltrimethoxysilane, methyltriethoxysilane, n-propyltriethoxysilane, hexyltriethoxysilane, octyltriethoxysilane, dimethyldimethoxysilane, dimethyldiethoxysilane, 3-aminopropyltrimethoxysilane, and 3-aminopropyltriethoxysilane. Aluminate coupling agents may include aluminum alkylacetoacetate diisopropylate, and titanate coupling agents may include triisostearoyloxy-isopropoxytitanium. The coupling agent may be of a single type or a mixture of two or more types.

The surface treatment agent is preferably added at 0.05 to 4 parts by mass per 100 parts by mass of the inorganic filler, more preferably 0.07 to 3.5 parts by mass, and even more preferably 1 to 3 parts by mass. This ensures good mixability and improves handleability, even when a large amount of inorganic filler is added to the fluoropolymer.

In addition to the fluoropolymer and the surface-treated inorganic filler, yet another additive may be added, such as a pigment, stabilizer, oil, alcohol, or resin.

The fluoropolymer is oriented in a surface direction of the fluororesin sheet. This structure is exhibited when sheets of a compound (mixture) of the fluoropolymer and the surface-treated inorganic filler are laminated and press-molded into a sheet, by repeatedly performing the lamination and the press-molding a plurality of times, and by performing parallel lamination or cross lamination. In addition, repeating the lamination and press-molding a plurality of times forms a structure in which the fluoropolymer is entangled with the inorganic filler and covers the inorganic filler. This provides a structure in which interfacial delamination between the inorganic filler and the fluoropolymer is eliminated. Due to the fluoropolymer being oriented in a surface direction, and interfacial delamination between the inorganic filler and the fluoropolymer being eliminated, the fluororesin sheet has high tensile strength in a plurality of directions and good handleability by itself without using a glass fiber cloth. With this structure, the fluororesin sheet has high tensile strength in the surface direction and good handleability by itself without using a glass fiber cloth. Of course, the use of a glass fiber cloth is not excluded, and a glass fiber cloth may also be laminated at any position. However, preferably, the glass fiber cloth is not used, and a fluororesin sheet alone is employed.

The fluororesin sheet preferably has a tensile strength of 5 MPa or greater, more preferably more than 5 MPa, and even more preferably 6 MPa or greater in both the lengthwise direction and the widthwise direction. The higher the upper limit the better, but in practice, the upper limit is preferably 100 MPa or less, and more preferably 95 MPa or less. This provides high strength in various directions and improved handleability.

The fluororesin sheet preferably has a breaking elongation of 1% or greater, more preferably 5% or greater, and more preferably 10% or greater, in both the lengthwise direction and the widthwise direction. Also, the upper limit is preferably 500% or less, and more preferably 400% or less. This provides high elongation in various directions and improved handleability.

The fluoropolymer is preferably at least one selected from a group consisting of polytetrafluoroethylene (PTFE), a perfluoroalkoxy alkane polymer (PFA), and a perfluoroethylene propene copolymer (FEP). In particular, a combination of PTFE as a main component of 50 mass% or greater and PFA and/or FEP as a secondary component of less than 50 mass% is preferable.

The fluororesin sheet contains preferably 10 to 4000 parts by mass of the inorganic filler, more preferably 30 to 3800 parts by mass, and even more preferably 50 to 3500 parts by mass, per 100 parts by mass of the fluororesin.

Each particle of the inorganic filler is preferably from 0.01 to 100 pm, more preferably 0.1 to 90 µm, and even more preferably 0.1 to 80 µm, in terms of D50: median diameter in a cumulative particle size distribution based on volume, measured by a laser diffraction light scattering method. This improves reinforcing properties.

The thickness of the fluororesin sheet is preferably 0.05 to 10.0 mm, more preferably 0.1 to 9 mm, and even more preferably 0.12 to 8 mm. This enables application to a variety of circuit boards.

The mass per unit area of the fluororesin sheet is preferably 80 to 40000 g/m², more preferably 160 to 30000 g/m², and more preferably 200 to 20000 g/m². This enables the production of circuit boards with different characteristics.

Preferably, the fluororesin sheet is able to be adhered to a metal foil having a surface roughness Rz of 0.85 or more and 2.0 or less, and has an adhesive strength with the metal foil of up to 40 N/cm in terms of peel strength. More preferably, the peel strength is 5.0 to 40 N/cm, and even more preferably 5.3 to 40 N/cm. This enables the application to a variety of circuit boards. Preferably, the solder heat resistance is such that when a 50 mm square sample of a copper-clad fluororesin substrate is floated in a solder bath at a temperature of 288°C for 10 minutes, its copper foil does not peel off or does not swell. This improves processability in soldering operations.

A metal-clad fluororesin substrate according to the present invention includes any of the above-described fluororesin sheets with a metal foil attached to at least one surface thereof. Preferably, the metal foil is attached to both surfaces or a plurality of layers. This enables the application to many circuit boards.

Preferably, the metal-clad fluororesin substrate has a dielectric loss tangent of 0.0001 to 0.003 at a frequency of 10 GHz. Preferably, the metal-clad fluororesin substrate has a relative permittivity of 1.5 to 20 at a frequency of 10 GHz. This enables the application to high-frequency circuit boards.

Preferably, the metal foil is a copper foil. This enables the application to high-frequency circuit boards.

A production method according to the present invention includes the following steps.
(1) First step:
   An aqueous dispersion of a fluoropolymer and an inorganic filler are mixed to form a compound, and this compound is press-molded to form a sheet. The term "compound" here has the same meaning as green body. It is preferable to perform press-molding at ordinary temperature (room temperature) and at a pressure of 0.5 to 4.0 MPa. For the compound, a mixing method such as self-rotating mixing, kneading with a kneader, shaking, three-roll mixing, or a pot mill can be adopted.
(2) Second step:
   The above sheet is laminated and press-molded to form a sheet. It is preferable to perform press-molding at ordinary temperature (room temperature) and at a pressure of 0.15 to 2.5 MPa. At this time, the lamination and press-molding may be repeated a plurality of times. The plurality of times is preferably 2 to 20 times, and more preferably 3 to 15 times. Also, the lamination may be performed in one direction (parallel lamination) or multiple directions (cross lamination). Consequently, the fluoropolymer has a structure in which it is laminated in the thickness direction of the fluororesin sheet and is oriented in the surface direction thereof. In addition, repeating the lamination and press-molding a plurality of times forms a structure in which the fluoropolymer is entangled with the inorganic filler and covers the inorganic filler. This provides a structure in which interfacial delamination between the inorganic filler and the fluoropolymer is eliminated. As mentioned above, the fluororesin sheet has high tensile strength in a plurality of directions and good handleability by itself without using a glass fiber cloth due to the synergistic effect achieved by the structure in which the fluoropolymer is laminated in the thickness direction of the fluororesin sheet and oriented in the surface direction thereof and the structure in which interfacial delamination between the inorganic filler and the fluoropolymer is eliminated.
(3) Third step:
   Next, the resulting sheet is rolled and then dried. The rolling is preferably rolling with rolls. The drying is preferably air drying (air drying at room temperature) or performed by heating at 150°C for 30 minutes.
(4) Fourth step:
   Next, the resulting sheet is degreased. The heating temperature during the degreasing is 200°C or more and below 300°C, preferably 210°C to 280°C, and more preferably 220°C to 260°C. At temperatures below 200°C, some material remains that cannot be degreased. Meanwhile, a temperature of 300°C or more may decompose the surface treatment agent and reduce its effectiveness, and may also result in issues such as an increased amount of decomposition of the fluoropolymer.

The treatment time for degreasing is preferably 10 minutes to 24 hours of heat treatment, more preferably 30 minutes to 20 hours, and even more preferably 1 to 16 hours. The fluororesin sheet when degreased preferably has a length of 30 to 30000 mm, a width of 20 to 1000 mm, and a thickness of 70 to 11000 µm. The degreasing treatment is preferably performed with at least one surface, preferably both surfaces, of the fluororesin sheet exposed to air. This eliminates unnecessary organic matter, such as a stabilizer, oil, alcohol, and a dispersant. If unnecessary organic matter remains in the fluororesin sheet, the organic matter may form bubbles and cause defects when heated to the heat press temperature (around the melting point of the fluororesin, namely 326°C) in the subsequent copper foil application step. In addition, the substances in the form of bubbles may corrode the copper foil, resulting in a lower peel strength of the copper foil. In the present invention, unnecessary organic matter is eliminated by degreasing the sheet, thereby making it possible to prevent defects caused by bubbles even when the sheet is heated to the heat press temperature (around the melting point of fluororesin, namely 326°C) in the subsequent copper foil application step. Degreasing may be performed at a reduced pressure of 0.1 to 10 kPa. Examples of degreasing devices may include an electrically heated oven, a circulating air heated oven, and an IR oven, and may be of either a batch type or a continuous type. The IR oven provides a greater degreasing effect in less time than the electrically heated oven. The IR oven can perform degreasing continuously for an extended time. Since degreasing of a thick sheet takes a long time, it is preferable to heat the sheet with an electrically heated oven and reduce the pressure after the sheet is sufficiently heated.

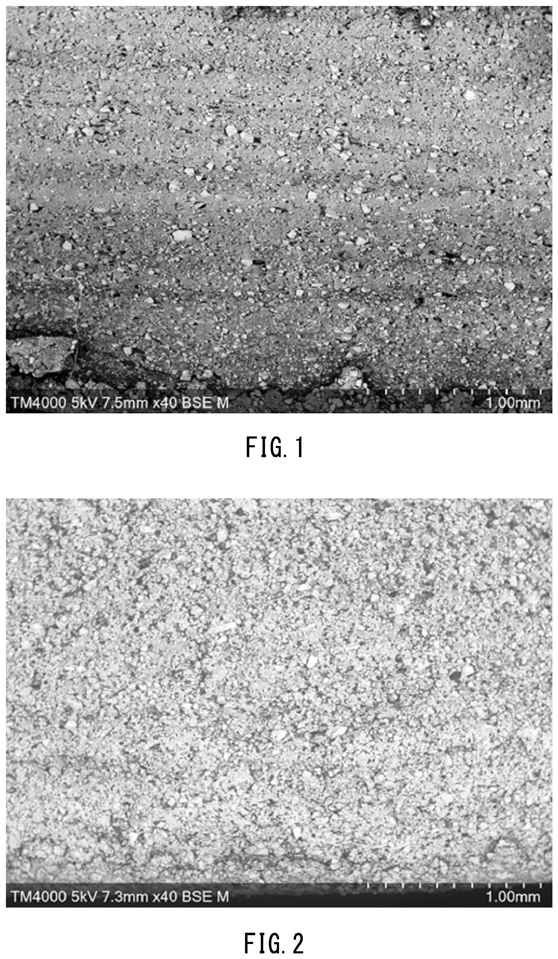

The following description will be given with reference to the drawings. In the following drawings, the same reference numerals denote the same elements. FIG. 1 is a cross-sectional scanning electron microscope (SEM) image of a fluororesin sheet 1 according to Example 1 of the present invention (magnified 40 times). The fluoropolymer is oriented in a surface direction of the fluororesin sheet. That is, the fluoropolymer is oriented laterally. Further, it can be observed that the fluororesin sheet has a structure in which the fluoropolymer is laminated in layers in the thickness direction. That is, the laminated structure is formed as seen from the cross-sectional direction.

FIG. 2 is a SEM image of a fluororesin sheet according to Comparative Example 1 (magnified 40 times). This fluororesin sheet is produced by a method without the second step (Lamination-pressing step) of the above-described method according to the present invention, and no orientation of the fluoropolymer is observed.

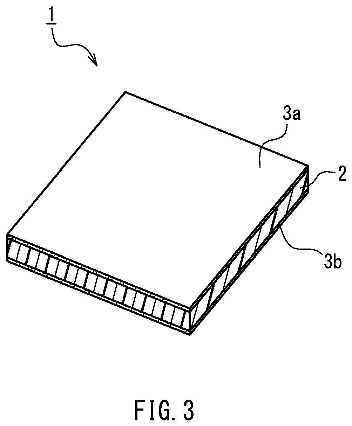

FIG. 3 is a schematic perspective diagram of a copper-clad fluororesin substrate 1 according to one embodiment of the present invention. In the copper-clad fluororesin substrate 1, copper foils 3a and 3b are attached to both surfaces of a fluororesin sheet 2. The fluororesin sheet 2 is heated to a temperature around the melting point, i.e., 326°C, and attached to the copper foils 3a and 3b by heat pressing. At this time, an adhesive may be used.

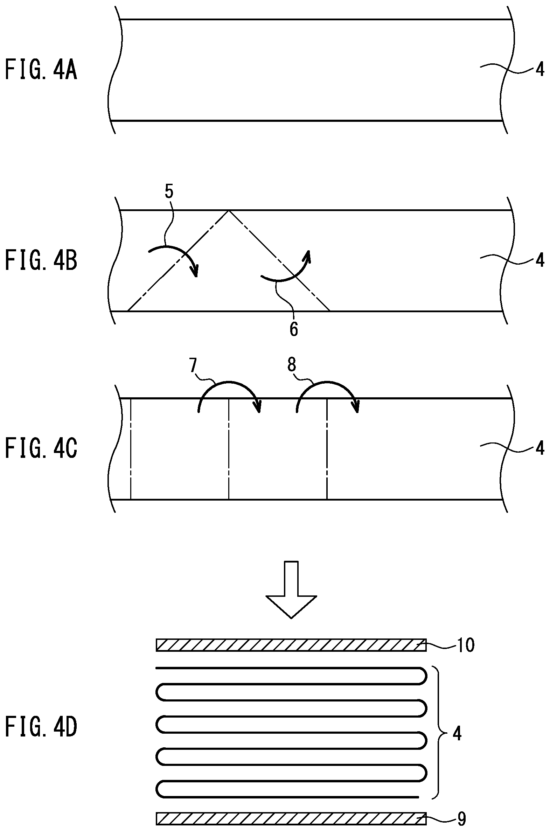

FIGS. 4A to 4D are schematic diagrams illustrating a method for producing the fluororesin sheet according to one embodiment of the present invention. FIG. 4A shows a fluororesin sheet 4 obtained in the first step of the above-described method according to the present invention. FIG. 4B shows an example of cross-laminating the fluororesin sheet 4 as indicated by arrows 5 and 6. Any angle of bending may be adopted. FIG. 4C shows the fluororesin sheet 4 subjected to parallel lamination as indicated by arrows 7 and 8. Mixed lamination may also be adopted in which the cross lamination in FIG. 4B and the parallel lamination in FIG. 4C are performed. The fluororesin sheet 4 laminated in this manner is pressed with press plates 10 and 11 as shown in FIG. 4D. Next, the rolling, drying, and degreasing steps are performed as described above, and thereafter the fluororesin sheet of the present invention is obtained.

### [Examples]

The following description will be made with reference to the examples. The present invention is not limited to the examples. In the following examples, unless otherwise stated, parts refers to parts by mass, and % refers to mass%. Various parameters were measured in the following manner.

### <Effective Relative Permittivity, Transmission Loss>

Transmission loss was measured using a network analyzer (manufactured by Keysight Technologies, Inc.).

### <Peel Strength (peel-off Strength)>

Peel-off strength was measured by peeling at 90° according to JIS C6481:1996 using a tensile tester (manufactured by Shimadzu Corporation).

### <Tensile Strength, Tensile Elongation>

Tensile strength tests and tensile elongation tests were conducted according to ASTM D638:1995 using a tensile tester (manufactured by Shimadzu Corporation). Note that the tensile strength and tensile elongation were measured on a 5 cm wide sample and converted to per cm. The term "elongation" refers to breaking elongation.

### <Thermal Resistance, Thermal Conductivity>

Thermal resistance was measured using a method conforming to ASTM D5470 (a sample is sandwiched between aluminum blocks, a load of 5 kgf is applied thereto, a thermal resistance value is measured from the temperature difference between the top and bottom as well as electric power, and a thermal conductivity is calculated from the thermal resistance value). Further, the thermal conductivity was calculated from the slope of the thermal resistance.

### <Solder Heat Resistance>

Solder heat resistance was examined by floating a 50 mm square sample of the copper-clad fluororesin substrate in a solder bath at a temperature of 288°C for 10 minutes and checking whether or not the copper foil peeled off or swelled.

### <Water Absorption>

Water absorption was measured by IPC-TM-650 2.6.2.1 (1986).

### <Generation of bubbles during copper foil application step>

Whether bubbles were generated when heating to the heat press temperature (around the melting point of fluororesin, namely 326°C) in the copper foil application step was measured by visual observation.

### <Other Physical Properties>

Other physical properties were measured in accordance with the industry standard testing.

### (Example 1)

### <Raw Material>

A liquid prepared by mixing 0.7 parts of trimethoxymethylsilane (DOWSIL SZ 6070 Silane, manufactured by Toray Industries, Inc.) and 24 parts of normalpropanol was dropped onto 100 parts of silicon oxide (F-40: manufactured by Marukama Kamado, Inc.) with a D50: median diameter of 5.6 pm in a cumulative particle size distribution based on volume, measured by a laser diffraction light scattering method, and was mixed by a Henschel mixer for 30 minutes. The mixed filler was heated by an oven at 100°C for 60 minutes to obtain a surface-treated filler.

An aqueous dispersion (60% concentration) of polytetrafluoroethylene (31-JR: manufactured by Chemours-Mitsui Fluoroproducts Co., Ltd.) was added to 132 parts of the surface-treated filler such that the resin content was 95 parts by volume, and an aqueous dispersion (60% concentration) of perfluoroethylene (335-JR: manufactured by Chemours-Mitsui) was added such that the resin content was 5 parts by volume. The resulting mixture was stirred to obtain a dispersion.

### <Mixing>

The resulting dispersion was stirred for 2 minutes with a propeller machine adjusted to a rotation speed of 60 to 70 rpm. Next, the dispersion was stirred for 2 minutes with a propeller machine at a rotation speed of 60 to 70 rpm.

### <Solidification>

The resulting dispersion was solidified.

### <Forming Compound (Green Body)>

The above-solidified dispersion was scooped out with a spatula or the like and kneaded.

### <Molding>

The resulting green body was placed in a metal frame with a 14 cm square inner frame and a thickness of 1.5 cm, and was press-molded at room temperature under a pressure of 2.0 MPa.

### <Lamination-pressing>

A molded body that had been soaked for a sufficient period of time was placed in a metal frame with a 21 cm square inner frame and a thickness of 0.65 cm, and press-molded at room temperature under a pressure of 1.5 MPa. Thereafter, the lamination shown in FIG. 4A and the lamination shown in FIG. 4B were performed once each, and then press-molding was performed at room temperature under a pressure of 1.0 MPa.

### <Rolling>

The resulting molded body was placed on a 100 pm thick polyethylene terephthalate (PET) film and rolled with a roll spacing of 3.5 mm. At this time, it is desirable to set the draft to a low value. Rolling was repeated until a predetermined thickness (about 0.16 mm) was reached.

### <Drying>

The sheet obtained by the above rolling was dried while placed on the PET film.

### <Degreasing>

The resulting dried sheet was cut to predetermined dimensions, placed in an electrically heated oven, and heated at 250°C for 12 hours. The size of the sheets was 10000 mm in length, 500 mm in width, and 100 pm in thickness. The degreasing treatment was performed while exposing at least one surface of the fluororesin sheet to the air.

### <Heat-pressing>

An elongated degreased sheet obtained in the degreasing step was cut to a predetermined size (as an example, 200 mm length and 300 mm width), stacked in the order of a copper foil (product name: "CF-T4X-SV18" manufactured by Fukuda Metal Foil & Powder Co., Ltd., surface roughness Rz: 1.0 µm), the degreased sheet, and a copper foil, gradually heated to a temperature of 350°C, and vacuum-heated and pressed at 0.9 kPa vacuum and 8.0 MPa pressure to form a laminated body.

FIG. 1 is a cross-sectional scanning electron microscope (SEM) image of the fluororesin sheet 1 according to Example 1 (magnified 40 times). It can be confirmed that the fluoropolymer is oriented in a surface direction of the fluororesin sheet. That is, the fluoropolymer is oriented laterally. Further, it can be observed that the fluororesin sheet has a structure in which the fluoropolymer is laminated in layers in the thickness direction. That is, the laminated structure is formed as seen from the cross-sectional direction.

### (Comparative Example 1)

Comparative Example 1 was implemented in the same manner as Example 1, except that the inorganic filler was not surface-treated and degreasing was not performed. FIG. 2 is a SEM image of a fluororesin sheet according to a Comparative Example 1 (magnified 40 times). This fluororesin sheet is produced by a method without the second step (lamination-press step) of the above-described method according to the present invention, and no orientation of the fluoropolymer is observed.

### (Example 2)

### <Raw Material>

A liquid prepared by mixing 0.3 parts of trimethoxymethylsilane (DOWSIL SZ 6070 Silane, manufactured by Toray Industries) and 7 parts of normalpropanol was dropped onto 100 parts of silicon oxide (LS-44: manufactured by Marukama Kamado Thuryou) with a D50: median diameter of 13.5 µm in a cumulative particle size distribution based on volume, measured by a laser diffraction light scattering method, and was mixed by a Henschel mixer for 30 minutes. The mixed filler was heated by an oven at 100°C for 60 minutes to obtain a surface-treated filler.

An aqueous dispersion (60% concentration) of polytetrafluoroethylene (31-JR: manufactured by Chemours-Mitsui) was added to 132 parts of the surface-treated filler such that the resin content was 95 parts by volume, and an aqueous dispersion (60% concentration) of perfluoroethylene (335-JR: manufactured by Chemours-Mitsui) was added such that the resin content was 5 parts by volume. The resulting mixture was stirred to obtain a dispersion.

### <Mixing>

The resulting dispersion was stirred for 2 minutes with a propeller machine adjusted to a rotation speed of 60 to 70 rpm. Next, the dispersion was stirred for 2 minutes with a propeller machine at a rotation speed of 60 to 70 rpm.

### <Solidification>

The resulting dispersion was solidified.

### <Forming Compound (Green Body)>

The above-solidified dispersion was scooped out with a spatula or the like and kneaded.

### <Molding>

The resulting green body was placed in a metal frame with a 14 cm square inner frame and a thickness of 1.5 cm, and was press-molded at room temperature under a pressure of 2.0 MPa.

### <Lamination-pressing>

A molded body that had been soaked for a sufficient period of time was placed in a metal frame with a 21 cm square inner frame and a thickness of 0.65 cm, and press-molded at room temperature under a pressure of 1.5 MPa. Thereafter, the lamination shown in FIG. 4A and the lamination shown in FIG. 4B were performed once each, and then press-molding was performed at room temperature under a pressure of 1.0 MPa.

### <Rolling>

The resulting molded body was placed on a 100 µm thick polyethylene terephthalate (PET) film and rolled with a roll spacing of 3.5 mm. At this time, it is desirable to set the draft to a low value. Rolling was repeated until a predetermined thickness (about 0.16 mm) was reached.

### <Drying>

The sheet obtained by the above rolling was dried while placed on the PET film.

### <Degreasing>

The resulting dried sheet was cut to predetermined dimensions, placed in an electrically heated oven, and heated at 250°C for 12 hours. The size of the sheets was 10000 mm in length, 500 mm in width, and 100 pm in thickness. The degreasing treatment was performed while exposing at least one surface of the fluororesin sheet to the air.

### <Heating Press>

An elongated degreased sheet obtained in the degreasing process was cut to a predetermined size (as an example, 200 mm length and 300 mm width), stacked in the order of a copper foil (product name: "CF-T4X-SV18" manufactured by Fukuda Metal Foil & Powder, surface roughness Rz: 1.0 µm), the degreased sheet, and a copper foil, gradually heated to a temperature of 350°C, and vacuum-heated and pressed at 0.9 kPa vacuum and 8.0 MPa pressure to form a laminated body.

### (Comparative Example 2)

Comparative Example 2 was implemented in the same manner as Example 2, except that the inorganic filler was not surface-treated and degreasing was not performed.

### (Example 3)

### <Raw Material>

A liquid prepared by mixing 1.0 part of triisostearoyl oxy-isopropoxy titanium (TTS: manufactured by Ajinomoto Fine-Techno Co., Ltd) and 8 parts of xylene was dropped onto 100 parts of silicon oxide (LS-44: manufactured by Marukama Kamado Touryou) with a D50: median diameter of 13.5 µm in a cumulative particle size distribution based on volume, measured by a laser diffraction light scattering method, and was mixed by a Henschel mixer for 30 minutes. The mixed filler was heated by an oven at 150°C for 60 minutes to obtain a surface-treated filler.

An aqueous dispersion (60% concentration) of polytetrafluoroethylene (31-JR: manufactured by Chemours-Mitsui) was added to 132 parts of the surface-treated filler such that the resin content was 95 parts by volume, and an aqueous dispersion (60% concentration) of perfluoroethylene (335-JR: manufactured by Chemours-Mitsui) was added such that the resin content was 5 parts by volume. The resulting mixture was stirred to obtain a dispersion.

### <Mixing>

The resulting dispersion was stirred for 2 minutes with a propeller machine adjusted to a rotation speed of 60 to 70 rpm. Next, the dispersion was stirred for 2 minutes with a propeller machine at a rotation speed of 60 to 70 rpm.

### <Solidification>

The resulting dispersion was solidified.

### <Forming Compound (Green Body)>

The above-solidified dispersion was scooped out with a spatula or the like and kneaded.

### <Molding>

The resulting green body was placed in a metal frame with a 14 cm square inner frame and a thickness of 1.5 cm, and was press-molded at room temperature under a pressure of 2.0 MPa.

### <Lamination-pressing>

A molded body that had been soaked for a sufficient period of time was placed in a metal frame with a 21 cm square inner frame and a thickness of 0.65 cm, and press-molded at room temperature under a pressure of 1.5 MPa. Thereafter, the lamination shown in FIG. 4A and the lamination shown in FIG. 4B were performed once each, and then press-molding was performed at room temperature under a pressure of 1.0 MPa.

### <Rolling>

The resulting molded body was placed on a 100 pm thick polyethylene terephthalate (PET) film and rolled with a roll spacing of 3.5 mm. At this time, it is desirable to set the draft to a low value. Rolling was repeated until a predetermined thickness (about 0.16 mm) was reached.

### <Drying>

The sheet obtained by the above rolling was dried while placed on the PET film.

### <Degreasing>

The resulting dried sheet was cut to predetermined dimensions, placed in an electric oven, and heated at 250°C for 12 hours. The size of the sheet was 10000 mm in length, 500 mm in width, and 100 pm in thickness. The degreasing treatment was performed while exposing at least one surface of the fluororesin sheet to the air.

### <Heat-pressing>

An elongated degreased sheet obtained in the degreasing process was cut to a predetermined size (as an example, 200 mm length and 300 mm width), stacked in the order of a copper foil (product name: "CF-T4X-SV18" manufactured by Fukuda Metal Foil & Powder, surface roughness Rz: 1.0 pm), the degreased sheet, and a copper foil, gradually heated to a temperature of 350°C, and vacuum-heated and pressed at 0.9 kPa vacuum and 8.0 MPa pressure to form a laminated body.

### (Comparative Example 3)

Comparative Example 3 was implemented in the same manner as in Example 3, except that the inorganic filler was not surface-treated and degreasing was not performed.

The results are summarized in Table 1.

**[Table 1]**

| | | Ex. 1 | Comp. Ex. 1 | Ex. 2 | Comp. Ex. 2 | Ex. 3 | Comp. Ex. 3 |
|---|---|---|---|---|---|---|---|
| Inorganic filler surface treatment | | Performed | Not performed | Performed | Not performed | Performed | Not performed |
| Generation of bubbles during copper foil application step | | Not generated | Generated | Not generated | Generated | Not generated | Generated |
| Relative permittivity (10 GHz) | | 2.68 | 2.70 | 2.65 | 2.61 | 2.61 | 2.61 |
| Dielectric loss tangent (10 GHz) | | 0.0015 | 0.0034 | 0.0006 | 0.0012 | 0.0006 | 0.0012 |
| Water absorption rate (%) | | 0.01 | 0.48 | 0.04 | 0.09 | 0.01 | 0.09 |
| Mass (g/m²) | | 2.08 | 1.95 | 2.08 | 2.14 | 2.13 | 2.14 |
| Tensile strength (MPa) | Lengthwise direction | 6.4 | 5.9 | 6.6 | 7.8 | 72 | 7.8 |
| | Widthwise direction | 5.7 | 5.6 | 7.8 | 82 | 6.5 | 82 |
| Elongation (%) | direction | 122 | 30 | 126 | 74 | 44 | 74 |
| | Widthwise direction | 106 | 29 | 233 | 236 | 12 | 236 |
| Maximum peel strength (N/cm) | | 20 | 15 | 27 | 28 | 33 | 28 |

As is clear from Table 1, no bubble was generated during the copper foil application step in Examples 1 to 3, and defect-free copper foil-clad laminates were obtained. Further, it was confirmed that the fluororesin sheets according to Examples 1 to 3 had lower water absorption rates and were unlikely to be affected by humidity due to the surface treatment performed on the inorganic fillers. Furthermore, in Examples 1 to 3, fluororesin sheets with good handleability could be obtained without using a glass fiber cloth, and it was confirmed that both physical and electrical properties were excellent.

### Industrial Applicability

The fluororesin sheet and the metal-clad fluororesin substrate including the same according to the present invention are useful for, for example, circuit boards for IoT devices and wearable devices, high-speed transmission FPCs, transceivers, high-speed communication boards, antenna boards, smartphones, smart watches, communication base station antennas, collision sensors, distance sensors, sensors in train monitoring systems, satellite communication antennas, intersection inspection sensors, security image sensors, runway foreign object detection systems, and river water level monitoring sensors with low transmission loss even when using high frequencies such as millimeter waves.

### Description of Reference Numerals

- 1: Copper-clad fluororesin substrate
- 2, 4: Fluororesin sheet
- 3a, 3b: Copper foil
- 5, 6, 7, 8: Folding direction
- 9, 10: Press plate

## Claims

1. A fluororesin sheet comprising:
a fluoropolymer; and
an inorganic filler,
wherein the fluoropolymer is oriented in a surface direction of the fluororesin sheet,
the inorganic filler is surface-treated, and
the fluoropolymer is a degreased sheet.

2. The fluororesin sheet according to claim 1,
wherein the inorganic filler is at least one selected from a group consisting of: silicon oxide; aluminum oxide; titanium oxide; aluminum nitride; boron nitride; silicon nitride, barium titanate; barium sulfate; magnesium hydroxide; glass particles; and other ceramic particles not listed above.

3. The fluororesin sheet according to claim 1 or 2,
wherein the surface treatment agent used in the surface treatment agent is at least one compound selected from a group consisting of: a silane coupling agent; an aluminate coupling agent; and a titanate coupling agent.

4. The fluororesin sheet according to any one of claims 1 to 3,
wherein the surface treatment agent used in the surface treatment agent is added at 0.05 to 4 parts by mass per 100 parts by mass of the inorganic filler.

5. The fluororesin sheet according to any one of claims 1 to 4,
wherein the fluororesin sheet has a tensile strength of 5 MPa or more in both a lengthwise direction and a widthwise direction.

6. The fluororesin sheet according to any one of claims 1 to 5,
wherein the fluoropolymer is at least one selected from a group consisting of polytetrafluoroethylene: PTFE, a perfluoroalkoxy alkane polymer: PFA, and a perfluoroethylene propene copolymer: FEP.

7. The fluororesin sheet according to any one of claims 1 to 6,
wherein the fluororesin sheet contains 10 to 4000 parts by mass of the inorganic filler per 100 parts by mass of fluororesin.

8. The fluororesin sheet according to any one of claims 1 to 7,
wherein each particle of the inorganic filler has a size of 0.01 to 100 pm in terms of D50: median diameter in a cumulative particle size distribution based on volume, measured by a laser diffraction light scattering method.

9. The fluororesin sheet according to any one of claims 1 to 8,
wherein the fluororesin sheet has a thickness of 0.005 to 10.0 mm.

10. The fluororesin sheet according to any one of claims 1 to 9,
wherein the fluororesin sheet is able to be adhered to a metal foil having a surface roughness: Rz of 0.6 or more and 2.0 or less, and has an adhesive strength with the metal foil of up to 40 N/cm in terms of peel strength.

11. A metal-clad fluororesin substrate comprising the fluororesin sheet according to any one of claims 1 to 10 with a metal foil attached to at least one surface of the fluororesin sheet.

12. The metal-clad fluororesin substrate according to claim 11,
wherein the metal-clad fluororesin substrate has a dielectric loss tangent of 0.0001 to 0.003 at a frequency of 10 GHz.

13. The metal-clad fluororesin substrate according to claim 11 or 12,
wherein the metal-clad fluororesin substrate has a relative permittivity of 1.5 to 20 at a frequency of 10 GHz.

14. The metal-clad fluororesin substrate according to any one of claims 11 to 13, wherein the metal foil is a copper foil.

15. A method for producing the fluororesin sheet according to any one of claims 1 to 10, the method comprising:
a first step of mixing an aqueous dispersion of a fluoropolymer and a pre-surface-treated inorganic filler to form a compound, and press-molding the compound to form a sheet;
a second step of laminating the sheet and press-molding the sheet to form a sheet;
a third step of rolling and thereafter drying the resulting sheet; and
a fourth step of degreasing the resulting sheet at a temperature of 200°C or more and below 300°C for 5 to 24 hours.
